# EUROPÄISCHE PATENTSCHRIFT

(11) **EP 1 819 794 B1**
(45) Veröffentlichungstag und Bekanntmachung des Hinweises auf die Patenterteilung: **26.11.2008**
(21) Anmeldenummer: 05808150.6
(22) Anmeldetag: 11.11.2005
(51) Int. Cl.: C09J 7/00, C09J 109/00

(54) **HITZEAKTIVIERBARES KLEBEBAND AUF DER BASIS VON NITRILKAUTSCHUK UND POLYVINYLBUTYRAL FÜR DIE VERKLEBUNG VON ELEKTRONISCHEN BAUTEILEN UND LEITERBAHNEN**
ADHESIVE STRIP THAT CAN BE ACTIVATED BY HEAT AND IS BASED ON NITRILE RUBBER AND POLYVINYL BUTYRAL FOR STICKING TOGETHER ELECTRONIC COMPONENTS AND STRIP CONDUCTORS
BANDE ADHESIVE ACTIVABLE A LA CHALEUR, A BASE DE CAOUTCHOUC NITRILE ET DE POLYVINYLBUTYRAL, DESTINEE AU COLLAGE DE COMPOSANTS ELECTRONIQUES ET DE PISTES CONDUCTRICES

(30) Priorität: 29.11.2004 DE 102004057651
(43) Veröffentlichungstag der Anmeldung: 22.08.2007
(73) Patentinhaber: tesa AG, 20253 Hamburg (DE)
(72) Erfinder: RING, Christian, 20259 Hamburg (DE); KRAWINKEL, Thorsten, 22457 Hamburg (DE)
(86) Internationale Anmeldenummer: PCT/EP2005/055912
(87) Internationale Veröffentlichungsnummer: WO 2006/058829

(56) Entgegenhaltungen:
- GB-A- 784 565
- PATENT ABSTRACTS OF JAPAN Bd. 010, Nr. 339 (C-385), 15. November 1986 (1986-11-15) & JP 61 143480 A (YOKOHAMA RUBBER CO LTD:THE), 1. Juli 1986 (1986-07-01) in der Anmeldung erwähnt
- PATENT ABSTRACTS OF JAPAN Bd. 2000, Nr. 25, 12. April 2001 (2001-04-12) & JP 2001 220557 A (TOMOEGAWA PAPER CO LTD), 14. August 2001 (2001-08-14)

## Beschreibung

Die Erfindung betrifft ein hitzeaktivierbares Klebeband mit geringem Fließvermögen bei hohen Temperaturen zur Verklebung von elektronischen Bauteilen und von flexiblen gedruckten Leiterbahnen (Flexible Printed Circuit Boards, FPCBs).

Flexible Printed Circuit Boards werden heutzutage in einer Vielzahl von elektronischen Geräten wie Handys, Radios, Computern, Druckern und vielen anderen eingesetzt. Sie sind aufgebaut aus Schichten von Kupfer und einem hochschmelzenden widerstandsfähigen Thermoplasten meistens Polyimid, seltener Polyester. Für die Herstellung dieser FPCBs werden häufig Klebebänder mit besonders hohen Ansprüchen eingesetzt. Zum einen werden zur Herstellung der FPCBs die Kupferfolien mit den Polyimidfolien verklebt, zum anderen werden auch einzelne FPCBs miteinander verklebt, in diesem Fall findet eine Verklebung von Polyimid auf Polyimid statt. Daneben werden die FPCBs auch auf andere Substrate geklebt.

An die Klebebänder, die für diese Verklebungen eingesetzt werden, werden sehr hohe Ansprüche gestellt. Da sehr hohe Verklebungsleistungen erreicht werden müssen, werden im Allgemeinen hitzeaktivierbare Klebebänder eingesetzt, die bei hohen Temperaturen verarbeitet werden. Diese Klebebänder dürfen während dieser hohen Temperaturbelastung bei der Verklebung der FPCBs, die häufig bei Temperaturen um 200 °C stattfindet, keine flüchtigen Bestandteile abgeben. Um eine hohe Kohäsion zu erreichen, sollten die Klebebänder während dieser Temperaturbelastung vernetzen. Hohe Drücke während des Verklebungsprozesses machen es nötig, dass die Klebebänder bei hohen Temperaturen nur eine geringe Fließfähigkeit besitzen. Dieses wird durch hohe Viskosität des unvernetzten Klebebandes oder durch eine schnelle Vernetzung erreicht. Zudem müssen die Klebebänder noch lötbadbeständig sein, das heißt, für eine kurze Zeit eine Temperaturbelastung von 288 °C überstehen.

Aus diesem Grund ist der Einsatz von reinen Thermoplasten nicht sinnvoll, obwohl diese sehr leicht aufschmelzen und für eine gute Benetzung der zu verklebenden Substrate sorgen und zu einer sehr schnellen Verklebung innerhalb von wenigen Sekunden führen. Andererseits sind diese bei hohen Temperaturen so weich, dass sie bei Verklebung unter Druck zum Herausquellen aus der Klebfuge neigen. Damit ist auch keine Lötbadbeständigkeit gegeben.

Üblicherweise werden für vernetzbare Klebebänder Epoxidharze oder Phenolharze eingesetzt, die mit bestimmten Härtern zu polymeren Netzwerken reagieren. In diesem speziellen Fall sind die Phenolharze nicht einsetzbar, da sie bei der Vernetzung Abspaltprodukte erzeugen, die freigesetzt werden und während der Aushärtung oder spätestens im Lötbad zu einer Blasenbildung führen.

Epoxidharze werden hauptsächlich in der Konstruktionsverklebung eingesetzt und ergeben nach der Aushärtung mit entsprechenden Vernetzern sehr spröde Klebmassen, die zwar hohe Klebfestigkeiten erreichen, aber kaum flexibel sind.

Eine Steigerung der Flexibilität ist für den Einsatz in FPCBs unumgänglich. Zum einen soll die Verklebung mit Hilfe eines Klebebandes geschehen, das idealerweise auf eine Rolle gewickelt ist, zum anderen handelt es sich um flexible Leiterbahnen, die auch gebogen werden müssen, gut zu erkennen am Beispiel der Leiterbahnen in einem Laptop, bei dem der aufklappbare Bildschirm über FPCBs mit den weiteren Schaltungen verbunden ist.

Eine Flexibilisierung dieser Epoxidharzkleber ist auf zwei Arten möglich. Zum einen existieren mit Elastomerketten flexibilisierte Epoxidharze, die aber durch die sehr kurzen Elastomerketten nur eine begrenzte Flexibilisierung erfahren. Die andere Möglichkeit ist, die Flexibilisierung durch die Zugabe von Elastomeren zu erreichen, die der Klebmasse zugegeben werden. Diese Variante hat den Nachteil, dass die Elastomere chemisch nicht vernetzt werden, wodurch nur solche Elastomere zum Einsatz kommen können, die bei hohen Temperaturen immer noch eine hohe Viskosität aufweisen.

Da die Klebebänder meistens aus Lösung hergestellt werden, ist es häufig schwierig, Elastomere zu finden, die langkettig genug sind, um bei hohen Temperaturen nicht zu fließen, andererseits aber noch in konventionellen Lösungsmitteln löslich sind.

Eine Herstellung über einen Hotmelt-Prozess ist bei vernetzenden Systemen nur sehr schwierig möglich, da eine frühzeitige Vernetzung während des Herstellprozesses vermieden werden muss.

Klebmassen auf Basis von (hydriertem) Nitrilkautschuk und Polyvinylacetalen, hauptsächlich Polyvinylbutyral, sind bekannt und zum Beispiel in der JP 03 068673 A und der JP 61 143 480 A beschrieben. Dabei ist der Gehalt an Epoxidharzen dermaßen hoch, dass es sich nicht mehr um flexible Klebebänder handelt, sondern um Klebstoffe. Ein Einsatz in flexiblen Leiterbahnen ist nicht beschrieben. JP 04 057 878 A, JP 04 057 879 A, JP 04 057 880 A und JP 03 296 587 A beschreiben Klebmassen für Kupfer-Polimid-Verbunde, wie sie auch in flexiblen Leiterbahnen eingesetzt werden, auf der Basis von Nitrilkautschuk, Polyvinylbutyral und Epoxidharzen. In allen diesen Schriften ist für eine Vernetzung eine α,β-ungesättigte Verbindung wie zum Beispiel ein Epoxyacrylat oder ähnliches nötig.

Aufgabe der Erfindung ist es somit, ein Klebeband bereitzustellen, dass hitzeaktivierbar ist, in der Hitze vernetzt, in der Hitze gut auf das zu verklebende Substrat auffließt, gute Haftung auf Polyimid zeigt und im unvernetzten Zustand löslich in organischen Lösungsmitteln ist.

Gelöst wird diese Aufgabe durch ein Klebeband, wie es in dem Hauptanspruch näher gekennzeichnet ist. Gegenstand der Unteransprüche sind vorteilhafte Weiterentwicklungen des Erfindungsgegenstandes.

Demgemäß ist Gegenstand der Erfindung ein hitzeaktivierbares Klebeband für die Verklebung von elektronischen Bauteilen und Leiterbahnen, umfassend eine Klebemasse, bestehend aus zumindest
a. einem Acrylnitril-Butadien-Copolymeren mit einem Gewichtsanteil von 40 bis 80 Gew.-%,
b. einem Polyvinylacetal mit einem Gewichtsanteil von 2 bis 30 Gew.-%,
c. einem Epoxidharz mit einem Gewichtsanteil von 10 bis 50 Gew.-% und
d. einem Härter,
wobei die Epoxidgruppen bei hohen Temperaturen mit dem Härter chemisch vernetzt werden.

Der allgemeine Ausdruck "Klebeband" umfasst im Sinne dieser Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen.

Gegenüber dem Stand der Technik, in dem für eine Vernetzung eine α,β-ungesättigte Verbindung wie zum Beispiel ein Epoxyacrylat oder ähnliches nötig ist, erfolgt die Vernetzung in der vorliegenden Erfindung allein durch chemische Reaktion der Epoxidgruppen mit unterschiedlichen Härtern in der Hitze hervorgerufen.

Als Nitrilkautschuke können in erfindungsgemäßen Klebmassen insbesondere alle Acrylnitril-Butadienkautschuke zum Einsatz kommen mit einem Acrylnitrilgehalt von 15 bis 50 Gew.-%. Ebenso sind auch Copolymere aus Acrylnitril-Butadien und Isopren einsetzbar. Dabei ist der Anteil von 1,2-verknüpftem Butadien variabel. Die vorgenannten Polymere können zu einem unterschiedlichen Grad hydriert sein; auch vollständig hydrierte Polymere mit einem Doppelbindungsanteil von unter 1 % sind nutzbar.

Kommerziell sind solche Systeme zum Beispiel unter dem Namen Nipol oder Breon von der Firma Zeon kommerzialisiert, hydrierte Systeme sind unter dem Namen Zetpol bei der Firma Zeon oder unter Therban bei der Firma Lanxess in unterschiedlichen Graden erhältlich.

Dabei zeigt sich, dass die Nitrilkautschuke mit höheren Acrylnitrilgehalten bessere Klebleistungen ergeben. Ebenfalls vorteilhaft für eine starke Verklebung ist ein hohes Molekulargewicht, wobei darauf geachtet werden muss, dass das Polymer noch in Lösung gebracht werden kann.

Polyvinylacetale im erfindungsgemäßen Sinne sind alle Polyvinylformale mit unterschiedlichen Gehalten an Polyvinylalkohol und bevorzugt Polyvinylbutyrale gewonnen aus Polyvinylalkohol. Der Gehalt an Polyvinylalkohol kann dabei zwischen 5 und 40 Gew.-% schwanken. Polyvinylbutyrale sind bevorzugt, da sie deutlich einfacher in Lösung zu bekommen sind.

Sowohl die Nitrilkautschuke als auch die Polyvinylbutyrale lassen sich in kurzkettigen Alkoholen und Ketonen wie Ethanol oder Butanon lösen. Dabei ist Butanon bevorzugt, da sich die restlichen Komponenten, besonders die Epoxidharze besser in Butanon lösen lassen.

Als Epoxidharze werden üblicherweise sowohl monomere als auch oligomere Verbindungen mit mehr als einer Epoxidgruppe pro Molekül verstanden. Dieses können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden, sind verwendbar. Ebenfalls sind elastisch modifizierte Epoxidharze einsetzbar.

Beispiele von Epoxidharzen sind Araldite^{™} 6010, CY-281^{™}, ECN^{™} 1273, ECN^{™} 1280, MY 720, RD-2 von Ciba Geigy, DER^{™} 331, 732, 736, DEN^{™} 432 von Dow Chemicals, Epon^{™} 812, 825, 826, 828, 830 etc. von Shell Chemicals, HPT^{™} 1071, 1079 ebenfalls von Shell Chemicals, Bakelite^{™} EPR 161, 166, 172, 191, 194 etc. der Bakelite AG .

Kommerzielle aliphatische Epoxidharze sind zum Beispiel Vinylcyclohexandioxide wie ERL-4206, 4221, 4201, 4289 oder 0400 von Union Carbide Corp.

Elastifizierte Epoxidharze sind erhältlich von der Firma Noveon unter dem Namen Hycar.

Epoxidverdünner, monomere Verbindungen mit mehreren Epoxidgruppen sind zum Beispiel Bakelite^{™} EPD KR, EPD Z8, EPD HD, EPD WF, etc. der Bakelite AG oder Polypox^{™} R 9, R12, R 15, R 19, R 20 etc. der Firma UCCP.

Weiter vorzugsweise enthält das Klebeband mehr als ein Epoxidharz.

Als Härter kommen unter anderem folgende Substanzen in Frage, wie sie in US 3,970,608 A näher beschrieben sind:
- Mehrwertige aliphatische Amine wie zum Beispiel Triethylentetramin
- Mehrwertige aromatische Amine wie zum Beispiel Isophorondiamin
- Guanidine wie zum Beispiel Dicyandiamid
- Mehrwertige Phenole
- Mehrwertige Alkohole
- Mehrwertige Mercaptane
- Mehrwertige Carbonsäuren
- Säureanhydride mit ein oder mehr Anhydridgruppen

Durch die chemische Vernetzung der Härter mit den Epoxidharzen werden sehr große Festigkeiten innerhalb des Klebefilms erreicht. Aber auch die Verklebungsfestigkeiten zum Polyimid sind ausgesprochen hoch.

Um die Adhäsion zu erhöhen, ist auch der Zusatz von mit den Elastomeren verträglichen Klebharzen möglich.

Als Klebrigmacher können in erfindungsgemäßen Haftklebemassen zum Beispiel nicht hydrierte, partiell- oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C₅-, C₅/C₉-oder C₉-Monomerströmen, Polyterpenharze auf Basis von α-Pinen und/oder β-Pinen und/oder δ-Limonen, hydrierte Polymerisate von bevorzugt reinen C₈- und C₉-Aromaten eingesetzt werden. Vorgenannte Klebharze können sowohl allein als auch im Gemisch eingesetzt werden.

Als weitere Additive können typischerweise genutzt werden:
- primäre Antioxidanzien wie zum Beispiel sterisch gehinderte Phenole
- sekundäre Antioxidanzien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Füllstoffe, wie zum Beispiel Siliziumdioxid, Glas (gemahlen oder in Form von Kugeln), Aluminiumoxide, Zinkoxide, Calciumcarbonate, Titandioxide, Ruße, Metallpulver, etc.
- Farbpigmente und Farbstoffe sowie optische Aufheller
- gegebenenfalls weitere Polymere von bevorzugt elastomerer Natur.

Durch den Einsatz von Weichmachern kann die Elastizität der vernetzten Klebmasse erhöht werden. Als Weichmacher können dabei zum Beispiel niedermolekulare Polyisoprene, Polybutadiene, Polyisobutylene oder Polyethylenglykole und Polypropylenglykole eingesetzt werden.

Da die beiden eingesetzten Polymere auch bei hohen Temperaturen keine zu niedrige Viskosität besitzen, kommt es während des Verklebens und Heißpressens nicht zum Austritt der Klebmasse aus der Klebfuge. Während dieses Vorgangs vernetzen die Epoxidharze mit den Härtern, es ergibt sich ein dreidimensionales Netzwerk.

Durch die Zugabe von so genannten Beschleunigern kann die Reaktionsgeschwindigkeit deutlich weiter erhöht werden.

Beschleuniger können zum Beispiel sein:
- tertiäre Amine wie Benzyldimethylamin, Dimethylaminomethylphenol, Tris(dimethylaminomethyl)phenol
- Bortrihalogenid-Amin-Komplexe
- substituierte Imidazole
- Triphenylphosphin

Idealerweise werden die Epoxidharze und die Härter in einem Mengenverhältnis eingesetzt, dass der molare Anteil an Epoxidgruppen und Härtergruppen gerade äquivalent ist. Das Verhältnis zwischen Härtergruppen und Epoxidgruppen kann aber in weiten Bereichen variiert werden, dabei sollte für eine ausreichende Vernetzung keine der beiden Gruppen in mehr als einem vierfachen moläquivalenten Überschuss vorliegen.

Zur Herstellung des Klebebandes werden die Bestandteile der Klebmasse in einem geeigneten Lösungsmittel, zum Beispiel Butanon, gelöst und auf ein flexibles Substrat, das mit einer Releaseschicht versehen ist, zum Beispiel einem Trennpapier oder einer Trennfolie beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden. Entsprechende Formkörper werden dann vorzugsweise bei erhöhter Temperatur auf das zu verklebende Substrat, zum Beispiel Polyimid, aufgeklebt.

Es ist auch möglich, die Klebmasse direkt auf einen Polyimidträger zu beschichten. Solche Klebfolien können dann zur Abdeckung von Kupferleiterbahnen für FPCBs eingesetzt werden.

Es ist nicht erforderlich, dass die Verklebung als einstufiges Verfahren erfolgt, sondern auf eines der beiden Substrate kann zunächst das Klebeband geheftet werden, indem man in der Wärme laminiert. Beim eigentlichen Heißklebeprozess mit dem zweiten Substrat (zweite Polyimidfolie oder Kupferfolie) härten die Epoxidgruppen dann ganz oder teilweise aus und die Klebstofffuge erreicht die hohe Verklebungsfestigkeit.

Die zugemischten Epoxidharze und die Härter sollten vorzugsweise bei der Laminiertemperatur noch keine chemische Reaktion eingehen, sondern erst bei der Heißverklebung miteinander reagieren.

Durch den Einsatz des Polyvinylacetals ist besonders die Temperaturstabilität der vernetzten Klebmasse deutlich verbessert.

Bevorzugt vernetzt das Klebeband bei Temperaturen über 150 °C.

### Beispiele

Im Folgenden wird die Erfindung durch einige Beispiele näher beschrieben, ohne dabei die Erfindung in irgendeiner Weise zu beschränken.

### Beispiel 1

50 Gew.% Breon N41 H80 (Nitrilkautschuk der Firma Zeon mit einem Acrylnitrilgehalt von 41 Gew.-% und einer Mooney-Viskosität ML 1+4 bei 100°C von 72 bis 88) werden zusammen mit 15 Gew.% Mowital B 60 HH (Polyvinylbutyral der Firma Kuraray mit einem Polyvinylalkoholgehalt von 12 bis 16 Gew.-%) in Butanon gelöst. Anschließend werden 30 Gew.% Bakelite EPR 166 (Epoxidharz mit einem Epoxidäquivalent von 184 der Firma Bakelite) und 5 Gew.% Dyhard 100-S (Dicyandiamid der Firma Degussa) zugegeben. Wenn alle Inhaltsstoffe mit Ausnahme des unlöslichen Dycyandiamids gelöst sind, wird die Lösung auf ein mit einer Release-Schicht versehenem Trennpapier ausgestrichen, so dass eine Schichtdicke von 25 µm nach der Trocknung resultiert.

### Beispiel 2

60 Gew.% Therban C 4369 (hydrierter Nitrilkautschuk der Firma Lanxess mit 43 Gew.-% Acrylnitrilgehalt, einer Mooney-Viskosität bei 100 °C von ca. 95 und einem Doppelbindungsgehalt von 5,5 %) wird mit 10 Gew.% Mowital B 75H (Polyvinylbutyral der Firma Kuraray mit einem Polyvinylalkoholgehalt von 18 bis 21 Gew.-%) wie im Beispiel 1 beschrieben gelöst und wie im Beispiel 1 mit Bakelite EPR 166 (26 Gew.-%) und Dyhard 100-S (4 Gew.-%) versetzt.

### Vergleichsbeispiel 3

70 Gew.-% Breon N41H80 werden in Butanon gelöst. Anschließend werden 25 Gew.-% Bakelite EPR 166 und 5 Gew.% Dyhard 100-S zugegeben.

### Vergleichsbeispiel 4

Dieses Beispiel entspricht Beispiel 1, allerdings mit einer veränderten Zusammensetzung: 30 Gew.-% Nitrilkautschuk, 10 Gew.-% Polyvinylbutyral, 54 Gew.-% Epoxidharz und 6 Gew.% Härter.

### Verklebung von FPCBs mit dem hergestellten Klebeband

Zwei FPCBs werden jeweils mit den nach den Beispielen 1 bis 4 hergestellten Klebebändern verklebt. Dazu wird das Klebeband auf die Polyimidfolie des FPCB-Laminats aus Polyimid/Kupferfolie bei 100 °C auflaminiert, wobei der Klebestreifen etwas kürzer als das zu verklebende FPCB ist, um später einen Anfasser zu haben. Anschließend wird eine zweite Polyimidfolie eines weiteren FPCBs auf das Klebeband geklebt und der ganze Verbund in einer beheizbaren Bürklepresse bei 200 °C bei einem Druck von 1,3 MPa für eine Stunde verpresst.

### Prüfmethoden

Die Eigenschaften der nach den oben genannten Beispielen hergestellten Klebstofffolien werden mit folgenden Testmethoden untersucht.

### T-Peel Test mit FPCB

Mit einer Zugprüfmaschine der Firma Zwick werden die nach dem oben beschriebenen Verfahren hergestellten Verbunde aus FPCB/Klebeband/FPCB im 180° Winkel mit einer Geschwindigkeit von 50 mm/min auseinander gezogen und die benötigte Kraft in N/cm gemessen. Die Messungen werden bei 20 °C und 50 % rel. Feuchte durchgeführt. Jeder Messwert wird dreifach bestimmt.

### Temperaturbeständigkeit

Analog zum beschriebenen T-Peel Test werden die nach dem oben beschriebenen Verfahren hergestellten FPCB-Verbunde so aufgehängt, dass einer der beiden entstandenen Anfasser oben befestigt wird, am anderen Anfasser wird ein Gewicht von 500 g befestigt, so dass sich zwischen den beiden FPCBs ein Winkel von 180° ausbildet. Der statische Schältest findet bei 70 °C statt. Gemessen wird der statische Schälweg in mm/h.

### Lötbadbeständigkeit

Die nach dem oben beschriebenen Verfahren verklebten FPCB-Verbunde werden für 10 Sekunden auf ein 288 °C heißes Lötbad gelegt. Die Verklebung wird als lötbadbeständig gewertet, wenn sich keine Luftblasen bilden, welche die Polyimidfolie des FPCBs aufblähen ließen. Der Test wird als nicht bestanden gewertet, wenn bereits eine leichte Blasenbildung eintrat.

### Ergebnisse:

Zur klebtechnischen Beurteilung der obengenanten Beispiele wurde zunächst der T-Peel Test durchgeführt.

Die Ergebnisse sind Tabelle 1 zu entnehmen.

**Tabelle 1**

| | T-Peel Test [N/cm] |
|---|---|
| Beispiel 1 | 14,3 |
| Beispiel 2 | 15,4 |
| Vergleichsbeispiel 3 | 10,7 |
| Vergleichsbeispiel 4 | 5,6 |

Wie aus den Beispielen zu ersehen ist, kann durch den Einsatz eines Gemisches aus Nitrilkautschuk und Polyvinylbutyral eine deutlich höhere Klebkraft erzielt werden, als durch Klebmassen mit Nitrilkautschuk allein. Wenn der Epoxidharzanteil zu hoch wird, wie in Beispiel 4, dann sinken die Klebkräfte aufgrund der starken Sprödigkeit.

Die Temperaturbeständigkeit der Klebebänder wurde mit dem statischen Peel-Test gemessen, dessen Werte in Tabelle 2 zu finden sind.

**Tabelle 2**

| | Statischer T-Peel Test bei 70 °C [mm/h] |
|---|---|
| Beispiel 1 | 3 |
| Beispiel 2 | 2 |
| Beispiel 3 | 16 |
| Beispiel 4 | 34 |

Wie zu erkennen ist, ist bei den Referenzmustern die Temperaturbeständigkeit niedriger als bei den Beispielen 1 und 2.

Der Lötbadtest wurde von allen 4 Beispielen bestanden.

## Patentansprüche

1. Hitzeaktivierbares Klebeband für die Herstellung und Weiterverarbeitung von flexiblen Leiterbahnen mit einer Klebmasse bestehend aus zumindest
a. einem Acrylnitril-Butadien-Copolymeren mit einem Gewichtsanteil von 40 bis 80 Gew.-%,
b. einem Polyvinylacetal mit einem Gewichtsanteil von 2 bis 30 Gew.-%,
c. einem Epoxidharz mit einem Gewichtsanteil von 10 bis 50 Gew.% und
d. einem Härter,
wobei die Epoxidgruppen bei hohen Temperaturen mit dem Härter chemisch vernetzt werden.

2. Hitzeaktivierbares Klebeband nach Anspruch 1 **dadurch gekennzeichnet, dass** es sich bei dem Polyvinylacetal um Polyvinylbutyral handelt.

3. Hitzeaktivierbares Klebeband nach Anspruch 1 oder 2, **dadurch gekennzeichnet, dass** das Acrylnitril-Butadien-Copolymer zumindest teilweise hydriert ist.

4. Hitzeaktivierbares Klebeband nach zumindest einem der Ansprüche 1 bis 3, **dadurch gekennzeichnet, dass** der Acrylnitrilgehalt in dem Acrylnitril-Butadienkautschuk 15 bis 50 Gew.-% beträgt.

5. Hitzeaktivierbares Klebeband nach zumindest einem der vorigen Ansprüche, **dadurch gekennzeichnet, dass** das Klebeband mehr als ein Epoxidharz enthält.

6. Hitzeaktivierbares Klebeband nach zumindest einem der vorigen Ansprüche, **dadurch gekennzeichnet, dass** das Klebeband klebrigmachende Harze, Beschleuniger, Farbstoffe, Ruß und/oder Metallpulver enthält.

7. Hitzeaktivierbares Klebeband nach zumindest einem der vorigen Ansprüche, **dadurch gekennzeichnet, dass** das Klebeband bei Temperaturen über 150°C vernetzt.

8. Hitzeaktivierbares Klebeband nach einem der vorigen Ansprüche, **dadurch gekennzeichnet, dass** das Klebeband noch weitere Elastomere enthält.

9. Verwendung eines hitzeaktivierbaren Klebebands gemäß zumindest einem der vorherigen Ansprüche zur Verklebung von flexiblen gedruckten Leiterbahnen.

10. Verwendung eines hitzeaktivierbaren Klebebands gemäß zumindest einem der vorherigen Ansprüche zur Verklebung auf Polyimid.

## Claims

1. Heat-activable adhesive tape for producing and further processing flexible conductor tracks, with an adhesive composed at least of
a. an acrylonitrile-butadiene copolymer, with a weight fraction of 40% to 80% by weight,
b. a polyvinyl acetal, with a weight fraction of 2% to 30% by weight,
c. an epoxy resin, with a weight fraction of 10% to 50% by weight, and
d. a hardener,
the epoxide groups being chemically crosslinked with the hardener at high temperatures.

2. The heat-activable adhesive tape of claim 1, **characterized in that** the polyvinyl acetal is polyvinyl butyral.

3. The heat-activable adhesive tape of claim 1 or 2, **characterized in that** the acrylonitrile-butadiene copolymer is at least partly hydrogenated.

4. The heat-activable adhesive tape of at least one of claims 1 to 3, **characterized in that** the acrylonitrile content of the acrylonitrile-butadiene rubber is 15% to 50% by weight.

5. The heat-activable adhesive tape of at least one of the preceding claims, **characterized in that** the adhesive tape comprises more than one epoxy resin.

6. The heat-activable adhesive tape of at least one of the preceding claims, **characterized in that** the adhesive tape comprises tackifying resins, accelerators, dyes, carbon black and/or metal powders.

7. The heat-activable adhesive tape of at least one of the preceding claims, **characterized in that** the adhesive tape crosslinks at temperatures above 150°C.

8. The heat-activable adhesive tape of one of the preceding claims, **characterized in that** the adhesive tape further comprises additional elastomers.

9. The use of a heat-activable adhesive tape of at least one of the preceding claims for bonding flexible printed conductor tracks.

10. The use of a heat-activable adhesive tape of at least one of the preceding claims for bonding to polyimide.

## Revendications

1. Bande adhésive thermoactivable pour la préparation et la transformation ultérieure de circuits imprimés souples, avec une masse adhésive constituée par au moins
a. un copolymère d'acrylonitrile-butadiène en une proportion pondérale de 40 à 80% en poids,
b. un polyvinylacétal en une proportion pondérale de 2 à 30% en poids,
c. une résine époxyde en une proportion pondérale de 10 à 50% en poids et
d. un durcisseur,
les groupes époxyde étant réticulés chimiquement à des températures élevées avec le durcisseur.

2. Bande adhésive thermoactivable selon la revendication 1, **caractérisée en ce qu'**il s'agit, pour le polyvinylacétal, de polyvinylbutyral.

3. Bande adhésive thermoactivable selon la revendication 1 ou 2, **caractérisée en ce que** le copolymère d'acrylonitrile-butadiène est au moins partiellement hydrogéné.

4. Bande adhésive thermoactivable selon au moins l'une quelconque des revendications 1 à 3, **caractérisée en ce que** la teneur en acrylonitrile dans le caoutchouc d'acrylonitrile-butadiène est de 15 à 50% en poids.

5. Bande adhésive thermoactivable selon au moins l'une quelconque des revendications précédentes, **caractérisée en ce que** la bande adhésive contient plus d'une résine époxyde.

6. Bande adhésive thermoactivable selon au moins l'une quelconque des revendications précédentes, **caractérisée en ce que** la bande adhésive contient des résines rendant adhésif, des accélérateurs, des colorants, de la suie et/ou de la poudre métallique.

7. Bande adhésive thermoactivable selon au moins l'une quelconque des revendications précédentes, **caractérisée en ce que** la bande adhésive réticule à des températures supérieures à 150°C.

8. Bande adhésive thermoactivable selon l'une quelconque des revendications précédentes, **caractérisée en ce que** la bande adhésive contient encore d'autres élastomères.

9. Utilisation d'une bande adhésive thermoactivable selon au moins l'une quelconque des revendications précédentes pour le collage de circuits imprimés, souples.

10. Utilisation d'une bande adhésive thermoactivable selon au moins l'une quelconque des revendications précédentes pour le collage sur du polyimide.
